(19) Europäisches Patentamt
European Patent Office
Office européen des brevets

(11) **EP 2 336 794 B1**

(12) **EUROPEAN PATENT SPECIFICATION**

(45) Date of publication and mention
of the grant of the patent:
**26.11.2014 Bulletin 2014/48**

(51) Int Cl.:
*G01R 31/02* $^{(2006.01)}$     *H01M 10/48* $^{(2006.01)}$
*G01R 19/00* $^{(2006.01)}$     *B60L 3/00* $^{(2006.01)}$
*H01M 10/42* $^{(2006.01)}$     *G01R 27/18* $^{(2006.01)}$
*G01R 31/36* $^{(2006.01)}$     *H01M 10/052* $^{(2010.01)}$

(21) Application number: **09810259.3**

(22) Date of filing: **01.09.2009**

(86) International application number:
**PCT/KR2009/004927**

(87) International publication number:
**WO 2010/024654 (04.03.2010 Gazette 2010/09)**

(54) **APPARATUS AND METHOD FOR SENSING A CURRENT LEAKAGE OF A BATTERY, AND BATTERY DRIVING APPARATUS AND BATTERY PACK INCLUDING THE APPARATUS**

VORRICHTUNG UND VERFAHREN ZUR ERFASSUNG DES LECKSTROMS EINER BATTERIE SOWIE BATTERIEANTRIEBSVORRICHTUNG UND BATTERIEPACK MIT DER VORRICHTUNG

APPAREIL ET PROCÉDÉ PERMETTANT LA DÉTECTION D'UNE FUITE DE COURANT D'UNE BATTERIE, APPAREIL PILOTE DE BATTERIE ET BLOC-BATTERIE COMPRENANT UN TEL APPAREIL

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **01.09.2008 KR 20080085756**
**01.09.2009 KR 20090082231**

(43) Date of publication of application:
**22.06.2011 Bulletin 2011/25**

(73) Proprietor: **LG Chem, Ltd.**
**Youngdungpo-gu**
**Seoul 150-721 (KR)**

(72) Inventors:
• **KANG, Ju-Hyun**
**Daejeon 305-340 (KR)**
• **KIM, Jee-Ho**
**Daejeon 305-791 (KR)**
• **LEE, Sang-Hoon**
**Daejeon, 305-738 (KR)**
• **KWON, Dong-Keun**
**Daejeon 305-308 (KR)**

(74) Representative: **Cabinet Plasseraud**
**52, rue de la Victoire**
**75440 Paris Cedex 09 (FR)**

(56) References cited:
**DE-A1-102006 050 529**     **FR-A1- 2 896 883**
**JP-A- 7 203 601**     **JP-A- 2004 006 190**
**JP-A- 2007 198 877**

**Description**

TECHNICAL FIELD

The present invention relates to apparatus and method for sensing a leakage current of a battery, and more particularly to apparatus and method for sensing a leakage current of a battery adopted in a battery power supply system demanding high voltage such as electric vehicles and hybrid vehicles.

BACKGROUND ART

In recent, along with exhaustion of fossil fuels and environmental contamination, more interests are taken in electric vehicles or hybrid vehicles(hereinafter, generally called electric vehicles), which may be driven by means of batteries without using fossil fuels.

Batteries used for electric vehicles are mostly secondary batteries. Secondary batteries are classified into lithium series batteries and nickel-hydrogen series batteries. Lithium series batteries are mainly applied to small-sized products such as digital cameras, P-DVD, MP3P, cellular phones, PDA, portable game devices, power tools and E-bikes, and nickel-hydrogen series are mainly applied to products demanding high power such as vehicles.

Any device using a battery needs to keep insulation between the battery and the device in a good state. Bad insulation of the battery causes a leakage current, which results in various problems. For reference, a leakage current of a battery causes unexpected discharge of the battery or malfunctions of electronic equipment included in the device. Also, a leakage current of a battery employed in an apparatus using a high voltage battery such as electric vehicles may give a fatal electric shock to a person. Accordingly, in the related art, it is demanded to develop a scheme for accurately and thoroughly detecting a leakage current of a battery.

Documents DE102006050529 describes a power supply isolation and contactor monitoring circuit arrangement for electric drive of motor vehicle and FR 2 896 883 relates to ground-fault resistance measurement circuit.

DISCLOSURE

Technical Problem

The present invention is designed to solve the above problems, and therefore the present invention is directed to providing apparatus and method for sensing a leakage current of a battery, which may sense a leakage current of a battery using a simple leakage current sensing circuit configuration in an easy and accurate way, and a battery pack and a battery-driven apparatus containing the above apparatus.

Technical Solution

In one aspect of the present invention, there is provided an apparatus for sensing a leakage current of a battery, which includes a floating capacitor charged with a voltage detected from a cathode terminal or an anode terminal of a battery; a DC (Direct Current) voltage applying unit for applying a DC voltage to the anode terminal when measuring a detection voltage of the anode terminal of the battery; a terminal selection switching unit for selecting a voltage detection path for the cathode terminal or the anode terminal; a charge switching unit for charging the floating capacitor with a detection voltage of the cathode or anode terminal, detected from the selected voltage detection path, and then separating the floating capacitor from the voltage detection path; a voltage sensing unit for sensing the detection voltage of the cathode or anode terminal, charged to the separated floating capacitor; and a leakage current determining unit for calculating a leakage resistance based on the detection voltages of the cathode and anode terminals of the battery, sensed by the voltage sensing unit, and then comparing the calculated leakage resistance with a criterion insulation resistance to determine whether a leakage current occurs or not.

The apparatus for sensing a leakage current of a battery according to the present invention further includes a first voltage distribution node installed on a first line between the cathode and anode terminals of the battery, wherein the terminal selection switching unit includes first and second switches respectively installed between the first voltage distribution node and the cathode and anode terminals of the battery.

The apparatus for sensing a leakage current of a battery according to the present invention further includes a second voltage distribution node installed on a second line between the first voltage distribution node and a ground, wherein the floating capacitor is installed on a fourth line diverged from a third line extending from the second voltage distribution node.

According to the present invention, the apparatus for sensing a leakage current of a battery may further include a voltage apply switching unit for applying the detection voltage of the cathode or anode terminal of the battery, charged to the floating capacitor, to the voltage sensing unit.

According to the present invention, the DC voltage applying unit may include a first switch installed between the second voltage distribution node and a ground; a second switch installed on a conduction line diverged between the second voltage distribution node and the first switch; and a DC power for applying a DC voltage to the second voltage distribution node when the second switch is turned on.

Preferably, the leakage current determining unit may include a switch controller for controlling operations of the terminal selection switching unit and the charge switching unit; an A/D (Analog/Digital) converter for converting an analog voltage signal output from the voltage sensing unit to a digital voltage signal; and a CPU (Central Processing Unit) for calculating a leakage resistance based on the digital voltage signal received from the A/D converter and then comparing the calculated leakage resistance with a criterion insulation resistance to determine whether a leakage current occurs or not.

Preferably, the voltage sensing unit may include a differential amplifier for sensing the voltage output from the floating capacitor.

Preferably, the leakage current determining unit may control the charge switching unit prior to detecting the voltage charged to the floating capacitor so that the floating capacitor is electrically separated from the selected voltage detection path.

According to the present invention, the leakage current determining unit may calculate a leakage resistance according to the following equation:

## Equation

$$R_{leakage} = R_i \times \frac{(E-V_A + V_B)}{(V_A - V_B)}$$

where $R_i$ is an internal resistance of the apparatus, E is a voltage of both ends of the battery, $V_A$ is the detection voltage of the cathode terminal charged to the floating capacitor, and $V_B$ is the detection voltage of the anode terminal charged to the floating capacitor.

According to the present invention, the leakage current determining unit may further include a leakage current alarming unit for visibly or audibly alarming the occurrence of a leakage current, and the leakage current alarming unit may make a visible or audible alarm in case a leakage current occurs.

Preferably, the leakage current determining unit may determine that a leakage current occurs, when the calculated leakage resistance is smaller than the criterion insulation resistance.

In another aspect of the present invention, there may be provided a battery pack, which includes the apparatus for sensing a leakage current of a battery as described above.

In still another aspect of the present invention, there may also be provided a battery-driven apparatus, which includes the apparatus for sensing a leakage current of a battery as described above.

In one aspect of the present invention, there is provided a method for sensing a leakage current of a battery, which includes (a) selecting a voltage detection path for a cathode terminal of a battery, charging a floating capacitor with a detection voltage of the cathode terminal of the battery, and sensing the charged detection voltage of the cathode terminal in a state that the floating capacitor is electrically separated from the voltage detection path; (b) selecting a voltage detection path for an anode terminal of the battery, applying a DC voltage to the anode terminal of the battery to charge the floating capacitor with a detection voltage of the anode terminal of the battery, and sensing the charged detection voltage of the anode terminal in a state that the floating capacitor is electrically separated from the voltage detection path; (c) calculating a leakage resistance based on the sensed detection voltages of the cathode and anode terminals; and (d) comparing the calculated leakage resistance with a criterion insulation resistance to determine whether a leakage current occurs or not.

Advantageous Effects

According to the present invention, voltage variations of both terminals of a battery caused by a leakage current is sensed using a floating capacitor to determine whether a leakage current occurs, so it is possible to prevent the accuracy of leakage voltage determination from being deteriorated due to a noise introduced from a battery pack or a load. In addition, it is possible to sense the occurrence of a leakage current of a battery at an early stage and then prevent the battery from being fully discharged. Also, it is possible to take protective measures against malfunctions or breakdown of internal electrical devices of a vehicle, caused by a leakage current, and also to prevent injury of humans caused by a leakage current of a battery. In addition, since the floating capacitor is electrically separated from the battery before the voltage charged to the floating capacitor is sensed, it is possible to decrease noise introduced from the battery, which allows more accurate detection of a leakage current.

DESCRIPTION OF DRAWINGS

The accompanying drawings illustrate the preferred embodiments of the present invention and are included to provide a further understanding of the spirit of the present invention together with the detailed description of the invention, and accordingly, the present invention should not be limitedly interpreted to only the matters shown in the drawings.

Fig. 1 is a circuit diagram showing an apparatus for sensing a leakage current of a battery according to a preferred embodiment of the present invention;
Fig. 2 is a block diagram showing a leakage current determining unit according to a preferred embodiment of the present invention;
Fig. 3 is a flowchart illustrating a method for sensing a leakage current of a battery according to a preferred embodiment of the present invention; and

BEST MODE

Hereinafter, preferred embodiments of the present invention will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best explanation. Therefore, the description proposed herein is just a preferable example for the purpose of illustrations only, not intended to limit the scope of the invention, so it should be understood that other equivalents and modifications could be made thereto without departing from the spirit and scope of the invention.

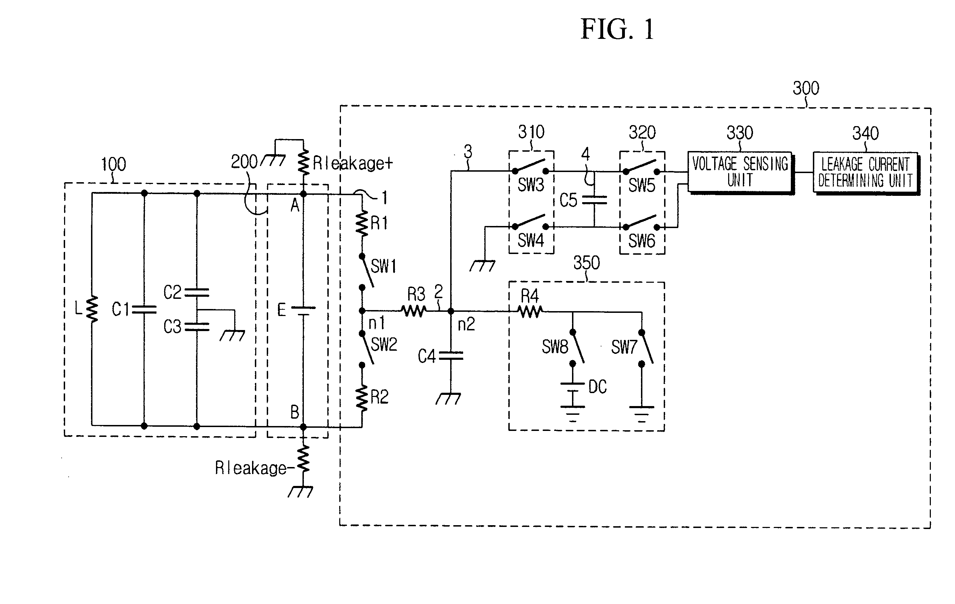

Fig. 1 is a circuit diagram showing an apparatus for sensing a leakage current of a battery according to a preferred embodiment of the present invention.

As shown in Fig. 1, a battery leakage current sensing apparatus 300 according to the present invention is connected to both terminals of a battery 200 having a plurality of cells and supplying power to a load system 100, so as to sense a leakage current of the battery 200.

In this embodiment, the load system 100 is a means using the electric energy output from the battery 200, and it may be a system demanding high power such as an electric vehicle or a hybrid vehicle. A load L of the load system 100, which consumes electric energy, may be a driving motor for transferring power to an electric vehicle or a hybrid vehicle, a DC-to-DC converter for converting a voltage level output from the battery 200, or the like. However, the load system 100 of the present invention and the load L included therein are not limited to the above. In the figure, a capacitor component C1 is a filter for filtering noise generated in the load system 100, and capacitor components C2 and C3 represent capacitor components present between the battery 200 and the load L when the battery 200 is connected to the load L.

The battery 200 is an electric energy storage means, and the battery 200 includes a plurality of electrically connected unit cells capable of being repeatedly charged and discharged. The unit cells are connected in series or in parallel. The unit cell is an electric double-layer capacitor including an ultra-capacitor, or a secondary battery such as a lithium ion battery, a lithium polymer battery, a nickel cadmium battery, a nickel hydrogen battery and a nickel zinc battery, well known in the art.

The battery leakage current sensing apparatus 300 according to the present invention includes a floating capacitor C5 charged with a voltage detected from a cathode terminal A or an anode terminal B of a battery 200, a DC voltage applying unit 350 for applying a DC voltage to the anode terminal B when measuring the detection voltage of the anode terminal B of the battery, a terminal selection switching unit SW1, SW2 for selecting a voltage detection path for the cathode terminal A or the anode terminal B, a charge switching unit SW3, SW4 for charging the floating capacitor C5 with the detection voltage of the cathode or anode terminal A, B detected from the selected voltage detection path, a voltage sensing unit 330 for sensing the detection voltage of the cathode terminal A or the anode terminal B of the battery charged to the floating capacitor C5, and a leakage current determining unit 340 for calculating a leakage resistance by using the detection voltage of the cathode and anode terminals A, B measured at the voltage sensing unit 330 and comparing the leakage resistance with a criterion insulation resistance to determine whether a leakage current occurs or not.

According to the present invention, a first line 1 is installed between the cathode terminal A and the anode terminal B of the battery 200. Also, a second line 2 is diverged from a first voltage distribution node n1 on the first line 1. The second line 2 is connected to the ground, and a second voltage distribution node n2 is located on the second line 2. A third line 3 is diverged from the second voltage distribution node n2, a third line 4 is diverged from the third line 3.

The terminal selection switching unit SW1, SW2 includes a first switch SW1 and a second switch SW2. The first switch SW1 is installed between the voltage distribution node n1 and the cathode terminal A of the battery 200, and the second switch SW2 is installed between the voltage distribution node n1 and the anode terminal B of the battery 200. Also, a first resistor R1 is installed between the first switch SW1 and the cathode terminal A, and a second resistor R2 is installed between the second switch SW2 and the anode terminal B.

The terminal selection switching unit selects a voltage detection path. The voltage detection path includes a voltage detection path for the cathode terminal A and a voltage detection path for the anode terminal B. The voltage detection path for the cathode terminal A is selected when the first switch SW1 of the terminal selection switching unit is turned on. On the contrary, the voltage detection path for the anode terminal B is selected when the second switch SW2 of the terminal selection switching unit is turned on.

A third resistor R3 is installed between the second voltage distribution node n2 and the first voltage distribution node n1. Also, a capacitor C4 is installed between the second voltage distribution node n2 and the ground. The capacitor C4 is primarily charged with the detection voltage of the cathode terminal A or the anode terminal B of the battery 200 according to selective turning-on of the terminal selection switching unit SW1, SW2.

The charge switching unit includes a third switch SW3 and a fourth switch SW4 connected to both terminals of a floating capacitor C5. If the charge switching unit is turned on, the detection voltage for the cathode terminal A or the anode terminal B primarily charged to the capacitor C4 is secondarily charged to the floating capacitor C5.

A voltage apply switching unit having a fifth switch SW5 and a sixth switch SW6 is interposed between the voltage sensing unit 330 and the floating capacitor C5. If the voltage applying switching unit is turned on, the voltage charged to the floating capacitor C5 is applied to the voltage sensing unit 330.

The voltage sensing unit 330 outputs voltages at both ends of the floating capacitor C5 to the leakage current determining unit 340 as analog voltage signals. In other words, the voltage sensing unit 330 subsequently senses the detection voltage for the cathode terminal A and the detection voltage for the anode terminal B, charged to the floating capacitor C5, to output analog voltage signals. The analog voltage signals include a first analog voltage signal corresponding to the detection voltage for the cathode terminal A and a second analog voltage signal corresponding to the polarity-reversed detection voltage for the anode terminal B. Preferably, the voltage sensing unit 330 may include a differential amplifier, but the present invention is not limited thereto.

The DC voltage applying unit 350 includes a fourth resistor R4 and a seventh switch SW7 subsequently installed between the second voltage distribution node n2 and the ground, an eighth switch SW8 installed on a conduction line diverged between the fourth resistor R4 and the seventh switch SW7, and a DC power DC for applying a positive DC voltage to the second voltage distribution node n2 when the eighth switch SW8 is turned on.

The DC voltage applying unit 350 allows the current, flowing from the cathode terminal A of the battery to the second line 2, to flow toward the ground when the voltage of the cathode terminal A of the battery is detected. Also, the DC voltage applying unit 350 applies a DC power to the anode terminal B when the voltage of the anode terminal B of the battery is detected, so that current flows from the second line 2 to the anode terminal B of the battery contrarily to the above. As a result, the voltages charged to the capacitor C4 and the floating capacitor C5 have the same polarity. As mentioned above, if the voltage charged to the floating capacitor C5 has the same polarity, the circuitry configuration of the voltage sensing unit 330 may be simplified.

A positive leakage resistance Rleakage+ and a negative leakage resistance Rleakage- depicted at both terminals of the battery 200 respectively represent a status when a leakage current occurs, and they equivalently express a virtual resistance value appearing when a leakage current occurs.

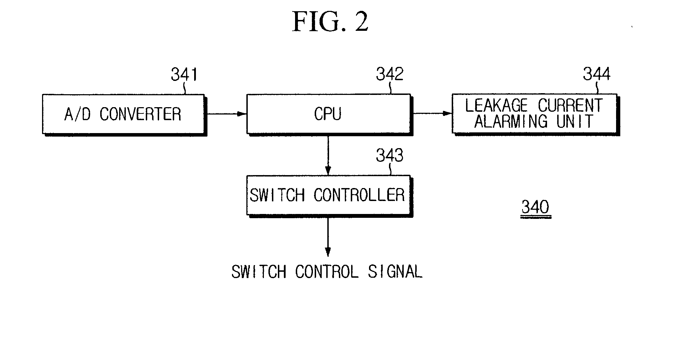

Fig. 2 is a block diagram showing a leakage current determining unit according to a preferred embodiment of the present invention.

Referring to Fig. 2, the leakage current determining unit 340 comprises an A/D converter 341, a central processing unit (CPU) 342, a switch controller 343 and a leakage current alarming unit 344.

The A/D converter 341 converts the analog voltage signal output from the voltage sensing unit 330 into a digital voltage signal. The digital voltage signal comprises a first digital voltage signal corresponding to the detection voltage of the cathode terminal A and a second digital voltage signal corresponding to the detection voltage of the anode terminal B.

The CPU 342 receives the digital voltage signal from the A/D converter 341 to calculate a leakage resistance. In other words, the CPU 342 classifies the digitalized voltage signals input from the A/D converter 341 into voltages of the cathode terminal A and the anode terminal B, and calculates a leakage resistance of the battery 200 according to the following equation 1 based on the digitalized voltage signals classified for cathode terminal and the anode terminal.

## Equation 1

$$R_{leakage} = R_i \times \frac{(E - V_A + V_B)}{(V_A - V_B)}$$

where, $R_i$ is an internal resistance of the leakage current sensing apparatus, E is voltage of both ends of the battery, $V_A$ is a detection voltage of the cathode terminal A, and $V_B$ is a detection voltage of the anode terminal B. In Fig. 1, if R1=R2, Ri=R1+R3+R4.

Also, the CPU 342 compares the leakage resistance calculated by the equation 1 with a preset criterion insulation resistance and determines that a leakage current occurs if the calculated leakage resistance is smaller than the criterion insulation resistance.

The switch controller 343 controls operations of the terminal selection switching unit SW1, SW2, the charge switching unit SW3, SW4, the voltage apply switching unit sW5, SW6, and the switches SW7, SW8 located in the DC voltage applying unit 350 under the control of the CPU 342.

In other words, the switch controller 343 controls the terminal selection switching unit SW1, SW2, the charge switching unit SW3, SW4, the voltage apply switching unit sW5, SW6, and the switches SW7, SW8 located in the DC voltage applying unit 350 so that the detection voltages for the cathode and anode terminals A, B of the battery 200 are subsequently stored to the capacitor C4 and the floating capacitor C5, and thus the stored detection voltages may be applied to the voltage sensing unit 330.

In a case where the detection voltage of the cathode terminal A is measured, the switch controller 343 turns on the first switch SW1 of the terminal selection switching unit and the seventh switch SW7 in the DC voltage applying unit 350, and turns off the second switch SW2 of the terminal selection switching unit and the eighth switch SW8 in the DC voltage applying unit 350 as well as a charge switching unit 310 and a voltage apply switching unit 320. Then, current flows from the cathode terminal A of the battery to the capacitor C4 and the seventh switch SW7, and as a result the capacitor C4 is charged with the voltage corresponding to the detection voltage of the cathode terminal A. Subsequently, the switch controller 343 turns off the first switch of the terminal selection switching unit and the seventh switch SW7 in the DC voltage applying unit 350 and turns on the charge switching unit 310 so that the detection voltage of the cathode terminal A charged to the capacitor C4 is charged again to the floating capacitor C5. Since the voltage apply switching unit 320 keeps a turning-off state while the voltage of the cathode terminal A is charged to the floating capacitor C5, it is possible to prevent noise introduced from the battery 200 or the load system 100 from flowing into the leakage current determining unit 340. After that, the voltage apply switching unit 320 is turned on in a state that the charge switching unit 310 is turned off so that the detection voltage for the cathode terminal A charged to the floating capacitor C5 is applied to the voltage sensing unit 330. Then, the voltage sensing unit 330 outputs a first analog voltage signal corresponding to the detection voltage of the cathode terminal A of the battery 200 to the A/D converter 341. Since the charge switching unit 310 is in a turning-off state when the voltage sensing unit 330 senses the detection voltage of the cathode terminal A, it is possible to prevent noise from flowing to the leakage current determining unit 340 from the battery 200 or the load system 100.

Then, in a case where the detection voltage of the anode terminal B is measured, the switch controller 343 turns off the first switch SW1 of the terminal selection switching unit, turns on the second switch SW2, turns off the seventh switch SW7 of the DC voltage applying unit 350, turns on the eighth switch SW8, and turns off the charge switching unit 310 and the voltage apply switching unit 320. Then, current flows from the cathode terminal of the DC power DC to the capacitor C4 and the anode terminal B of the battery, and in this process, the voltage corresponding to the detection voltage of the anode terminal B of the battery is charged to the capacitor C4. Subsequently, the switch controller 343 turns off the second switch SW2 of the terminal selection switching unit and the eighth switch SW8 of the DC voltage applying unit 350 and turns on the charge switching unit 310. Then, the detection voltage of the anode terminal B charged to the capacitor C4 is charged again to the floating capacitor C5. Since the voltage apply switching unit 320 keeps a turning-off state while the detection voltage of the anode terminal B is charged to the floating capacitor C5, it is possible to prevent noise from flowing into the leakage current determining unit 340 from the battery 200 or the load system 100. After that, the voltage apply switching unit 320 is turned on in a state that the charge switching unit 310 is turned off so that the detection voltage of the anode terminal B charged to the floating capacitor C5 is applied to the voltage sensing unit 330. Then, the voltage sensing unit 330 outputs a second analog voltage signal corresponding to the detection voltage of the anode terminal B of the battery to the A/D converter 341. Since the charge switching unit 310 is in a turning-off state when the voltage sensing unit 330 senses the detection voltage of the anode terminal B, it is possible to prevent noise from flowing into the leakage current determining unit 340 from the battery 200 or the load system 100.

Meanwhile, the voltage sensing unit 330 may be realized using a differential amplifier. However, since the floating capacitor C5 is always charged with a positive voltage, the voltage sensing unit 330 may be realized with only one differential amplifier without comprising a polarity reverse circuit in the voltage sensing unit 330.

According to the present invention, the leakage current determining unit 340 may audibly or visibly output a determining result whether a leakage current occurs or not. For this purpose, the leakage current determining unit 340 may further comprise a leakage current alarming unit 344.

In this case, if it is determined that a leakage current occurs, the leakage current determining unit 340 outputs a leakage current occurrence signal to the leakage current alarming unit 344. Then, the leakage current alarming unit 344 makes an audible or visible alarm to notify the occurrence of leakage current. The leakage current alarming unit 344 may be LED, LCD, an alarm device or their combinations. Thus, the leakage current alarming unit 344 makes an alarm about the occurrence of leakage current to a user by blinking LED, outputting an alarm message on an LCD or generating an alarming sound through an alarm device. However, it would be obvious that the present invention is not limited to the above but may be modified in various ways by adopting various kinds of visible or audible alarming devices as the leakage current alarming unit 344.

The battery leakage current sensing apparatus according to the present invention may be coupled to a battery-driven apparatus that receives power from a battery.

As one example, the leakage current sensing apparatus of the present invention may be comprised in various electronic products receiving a power from a battery, such as notebooks, mobile phones and personal portable multimedia regenerators.

As another example, the leakage current sensing apparatus of the present invention may be comprised in various power-driven apparatuses having a battery loaded therein, such as fossil fuel vehicles, electric vehicles, hybrid vehicles and electric bicycles.

Further, it would be apparent to those having ordinary skill in the art that the leakage current sensing apparatus of the present invention may be modulated into a PCB circuit or an on-demand semiconductor circuit (e.g., ASIC: Application-Specific Integrated Circuit) and then loaded in a battery pack.

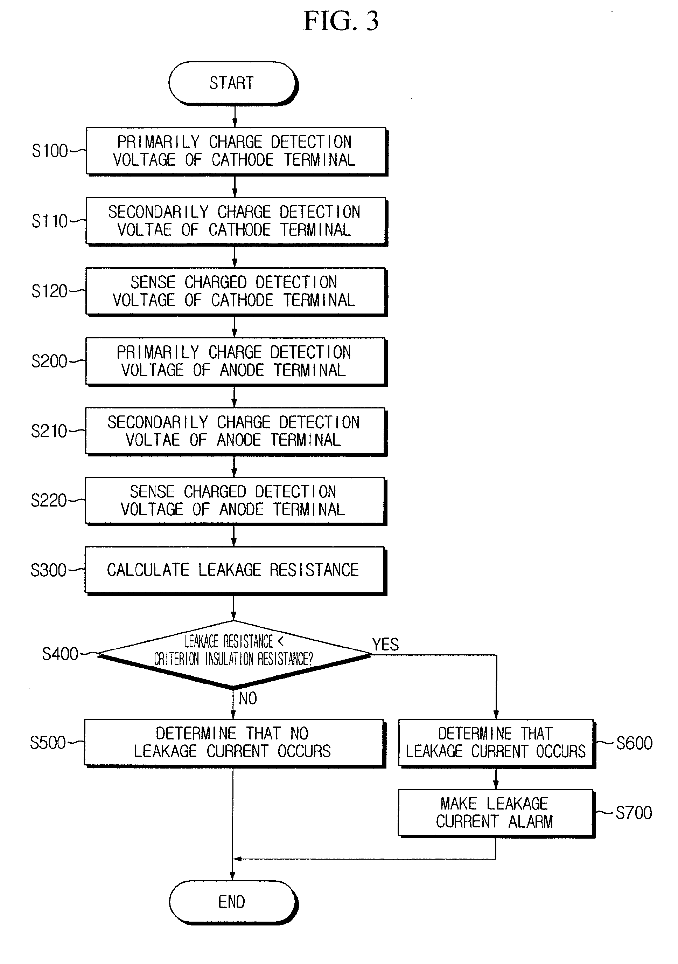

Fig. 3 is a flowchart illustrating a method for sensing a leakage current of a battery according to a preferred embodiment of the present invention.

It should be noted that, if there is no special mention, each step described below is executed by the CPU 342, and operations of each switch are accompanied with the control of the switch controller 343 by the CPU 342.

First, in order to sense the detection voltage of the cathode terminal A of the battery in a step S100, the first switch SW1 of the terminal selection switching unit is turned on, the second switch SW2 is turned off, the seventh switch SW7 of the DC voltage applying unit 350 is turned on, the eighth switch SW8 is turned off, and the charge switching unit 310 and the voltage apply switching unit 320 are turned off. Then, the voltage corresponding to the detection voltage of the cathode terminal A is primarily charged to the capacitor C4.

Subsequently, in a step S110, the first switch SW1 of the terminal selection switching unit and the seventh switch SW7 of the DC voltage applying unit 350 are turned off and the charge switching unit 310 is turned on so that the detection voltage of the cathode terminal A charged to the capacitor C4 is secondarily charged to the floating capacitor C5 again.

After that, in a step S120, the voltage switching unit 320 is turned on in a state that the charge switching unit 310 is turned off so that the detection voltage of the cathode terminal charged to the floating capacitor C5 is applied to the voltage sensing unit 330. Then, the voltage sensing unit 330 senses the detection voltage of the cathode terminal A and outputs a first analog voltage signal to the A/D converter 341. As a response, the A/D converter 341 converts the first analog voltage signal into a digitalized voltage signal and inputs the digitalized voltage signal to the CPU 342.

Then, in a step S200, in order to sense the detection voltage of the anode terminal B of the battery 200, the first switch SW1 of the terminal selection switching unit is turned off, the second switch SW2 is turned on, the seventh switch SW7 of the DC voltage applying unit is turned off, the eighth switch SW8 is turned on, and the charge switching unit 310 and the voltage apply switching unit 320 are turned off. Then, the DC power included in the DC voltage applying unit 350 is applied to the anode terminal B of the battery 200 to flow current to the anode terminal B of the battery 200 and the capacitor C4 so that the voltage corresponding to the detection voltage of the anode terminal B is primarily charged to the capacitor C4.

Subsequently, in a step S210, the second switch SW2 of the terminal selection switching unit and the eighth switch SW8 of the DC voltage applying unit 350 are turned off and the charge switching unit 310 is turned on so that the detection voltage of the anode terminal B charged to the capacitor C4 is secondarily charged to the floating capacitor C5 again.

After that, in a step S220, the voltage apply switching unit 320 is turned on in a state that the charge switching unit 310 is turned off so that the detection voltage of the anode terminal B charged to the floating capacitor C5 is applied to the voltage sensing unit 330. Then, the voltage sensing unit 330 senses the detection voltage of the anode terminal B and outputs a second analog voltage signal to the A/D converter 341. As a response, the A/D converter 341 converts the second analog voltage signal into a digitalized voltage signal and inputs the digitalized voltage signal to the CPU 342.

In a step S300, a leakage resistance is calculated based on the detection voltages of the cathode and anode terminals A and B, measured in the steps S110 and S210.

In a step S400, the leakage resistance calculated in the step S300 is compared with a criterion insulation resistance to determine whether the calculated leakage resistance is smaller than the criterion insulation resistance.

A step S500 is executed when the leakage resistance calculated in the step S400 is equal to or greater than the criterion insulation resistance, and it is determined that a leakage current does not in the battery.

A step S600 is executed when the leakage resistance calculated in the step S400 is smaller than the criterion insulation resistance, and it is determined that a leakage current occurs in the battery.

In a step S700, as it is determined in the step S600 that a leakage current occurs, a visible or audible alarm is generated.

The steps S100 to S700 may be selectively executed when it is required to detect a leakage current while the battery power system is in operation, or automatically repeated at a predetermined cycle.

INDUSTRIAL APPLICABILITY

According to the present invention, voltage variations of both terminals of a battery caused by a leakage current are sensed using a floating capacitor to determine whether a leakage current occurs, so it is possible to prevent the accuracy of leakage voltage determination from being deteriorated due to a noise introduced from a battery pack or a load. In addition, it is possible to sense the occurrence of a leakage current of a battery at an early stage and then prevent the battery from being fully discharged. Also, it is possible to take protective measures against malfunctions or breakdown of internal electrical devices of a vehicle, caused by a leakage current, and also to prevent injury of humans caused by a leakage current of a battery.

In another aspect of the present invention, since the floating capacitor is electrically separated from the battery before the voltage charged to the floating capacitor is sensed, it is possible to decrease noise introduced from the battery, which allows more accurate detection of a leakage current.

**Claims**

1. An apparatus for sensing a leakage current of a battery (200), comprising:

    a floating capacitor (C5) charged with a voltage detected from a positive terminal (A) or a negative terminal (B) of a battery (200);
a DC (Direct Current) voltage applying unit (350) for applying a DC voltage to the negative terminal (B) when measuring a detection voltage of the negative terminal (B) of the battery (200);
a terminal selection switching unit for selecting a voltage detection path for the positive terminal (A) or the negative terminal (B);
a charge switching unit for charging the floating capacitor (C5) with a detection voltage of the positive or negative terminal, detected from the selected voltage detection path, and then separating the floating capacitor (C5) from the voltage detection path;
a voltage sensing unit (330) for sensing the detection voltage of the positive or negative terminal, charged to the separated floating capacitor (C5); and
a leakage current determining unit (340) for calculating a leakage resistance based on the detection voltages of the positive and negative terminals of the battery (200), sensed by the voltage sensing unit (330), and then comparing the calculated leakage resistance with a criterion insulation resistance to determine whether a leakage current occurs or not.

2. The apparatus for sensing a leakage current of a battery (200) according to claim 1, further comprising a first voltage distribution node installed on a first line between the positive and negative terminals of the battery (200),
wherein the terminal selection switching unit includes first and second switches respectively installed between the first voltage distribution node and the positive and negative terminals of the battery (200).

3. The apparatus for sensing a leakage current of a battery (200) according to claim 1, further comprising a second voltage distribution node installed on a second line (2) between the first voltage distribution node and a ground,
wherein the floating capacitor (C5) is installed on a fourth line diverged from a third line (3) extending from the second voltage distribution node.

4. The apparatus for sensing a leakage current of a battery (200) according to claim 1, further comprising a voltage apply switching unit for applying the detection voltage of the positive or negative terminal of the battery (200), charged to the floating capacitor (C5), to the voltage sensing unit (330).

5. The apparatus for sensing a leakage current of a battery (200) according to claim 1, wherein the DC voltage applying unit (350) includes:

a first switch installed between the second voltage distribution node and a ground;
a second switch installed on a conduction line diverged between the second voltage distribution node and the first switch; and
a DC power for applying a DC voltage to the second voltage distribution node when the second switch is turned on.

6. The apparatus for sensing a leakage current of a battery (200) according to claim 1, wherein the leakage current determining unit (340) includes:

a switch controller (343) for controlling operations of the terminal selection switching unit and the charge switching unit;
an A/D (Analog/Digital) converter (341) for converting an analog voltage signal output from the voltage sensing unit (330) to a digital voltage signal; and
a CPU (Central Processing Unit) (342) for calculating a leakage resistance based on the digital voltage signal received from the A/D converter (341) and then comparing the calculated leakage resistance with a criterion insulation resistance to determine whether a leakage current occurs or not.

7. The apparatus for sensing a leakage current of a battery (200) according to claim 6, wherein the voltage sensing unit (330) includes a differential amplifier for sensing the voltage output from the floating capacitor (C5).

8. The apparatus for sensing a leakage current of a battery (200) according to claim 1, wherein the leakage current determining unit (340) controls the charge switching unit prior to detecting the voltage charged to the floating capacitor (C5) so that the floating capacitor (C5) is electrically separated from the selected voltage detection path.

9. The apparatus for sensing a leakage current of a battery (200) according to claim 1, wherein the leakage current determining unit (340) calculates a leakage resistance according to the following equation:

Equation

$$R_{leakage} = R_i \times \frac{(E - V_A + V_B)}{(V_A - V_B)}$$

where $R_i$ is an internal resistance of the apparatus, E is a voltage of both ends of the battery, $V_A$ is the detection voltage of the positive terminal (A) charged to the floating capacitor (C5), and $V_B$ is the detection voltage of the negative terminal (B) charged to the floating capacitor (C5).

10. The apparatus for sensing a leakage current of a battery (200) according to claim 1,
wherein the leakage current determining unit (340) further comprises a leakage current alarming unit (344) for visibly or audibly alarming the occurrence of a leakage current, and
wherein the leakage current alarming unit (344) makes a visible or audible alarm in case a leakage current occurs.

11. The apparatus for sensing a leakage current of a battery (200) according to claim 1, wherein the leakage current determining unit (340) determines that a leakage current occurs, when the calculated leakage resistance is smaller than the criterion insulation resistance.

12. A battery pack, which comprises the apparatus for sensing a leakage current of a battery (200) as defined in any one of claims 1 to 11.

13. A battery-driven apparatus, which comprises the apparatus for sensing a leakage current of a battery as defined in any one of claims 1 to 11.

14. A method for sensing a leakage current of a battery (200), comprising:

(a) selecting a voltage detection path for a positive terminal (A) of a battery, charging a floating capacitor (C5) with a detection voltage of the positive terminal (A) of the battery, and sensing the charged detection voltage of the positive terminal (A) in a state that the floating capacitor (C5) is electrically separated from the voltage detection path;
(b) selecting a voltage detection path for a negative terminal (B) of the battery (200), applying a DC voltage to the negative terminal (B) of the battery to charge the floating capacitor (C5) with a detection voltage of the negative terminal (B) of the battery, and sensing the charged detection voltage of the negative terminal (B) in a state that the floating capacitor (C5) is electrically separated from the voltage detection path;
(c) calculating a leakage resistance based on the sensed detection voltages of the positive and negative terminals; and
(d) comparing the calculated leakage resistance with a criterion insulation resistance to determine whether a leakage current occurs or not.

15. The method for sensing a leakage current of a battery (200) according to claim 14,

wherein, in the step (c), the leakage resistance is calculated according to the following equation:

$$\text{Equation}$$

$$R_{leakage} = R_i \times \frac{(E - V_A + V_B)}{(V_A - V_B)}$$

where $R_i$ is an internal resistance of the apparatus, E is a voltage of both ends of the battery, $V_A$ is the detection voltage of the positive terminal (A) charged to the floating capacitor (C5), and $V_B$ is the detection voltage of the negative terminal (B) charged to the floating capacitor (C5).

16. The method for sensing a leakage current of a battery (200) according to claim 14, further comprising:

making a visual or audible alarm in case it is determined that a leakage current occurs.

17. The method for sensing a leakage current of a battery (200) according to claim 14, wherein it is determined that a leakage current occurs, when the calculated leakage resistance is smaller than the criterion insulation resistance.

**Patentansprüche**

1. Vorrichtung zum Erfassen eines Ableitstroms einer Batterie (200) mit:

einem potentialfreien Kondensator (C5), der mit einer Spannung aufgeladen wird, die aus einem positiven Anschluss (A) oder einem negativen Anschluss (B) einer Batterie (200) detektiert wird;
einer DC(Gleichstrom)-Spannungsanlegeeinheit (350) zum Anlegen einer DC-Spannung an den negativen Anschluss (B), wenn eine Detektionsspannung des negativen Anschlusses (B) einer Batterie (200) gemessen wird;
einer Anschlusswahl-Schalteinheit zum Auswählen eines Spannungsdetektionspfades für den positiven Anschluss (A) oder den negativen Anschluss (B);
einer Auflade-Schalteinheit zum Aufladen des potentialfreien Kondensators (C5) mit einer Detektionsspannung des positiven oder negativen Anschlusses, die aus dem ausgewählten Spannungsdetektionspfad detektiert wurde, und dann zum Abtrennen des potentialfreien Kondensators (C5) vom Spannungsdetektionspfad;
einer Spannungserfassungseinheit (330) zum Erfassen der Detektionsspannung des positiven oder negativen Anschlusses, die auf den abgetrennten potentialfreien Kondensators (C5) geladen wurde; und

einer Ableitstrom-Bestimmungseinheit (340) zum Berechnen eines Ableitwiderstandes auf Basis der Detektionsspannungen des positiven und negativen Anschlusses der Batterie (200), die durch die Spannungserfassungseinheit (330) erfasst wurden, und dann zum Vergleichen des berechneten Ableitwiderstandes mit einem Isolationswiderstandsrichtwert, um zu bestimmen, ob ein Ableitstrom auftritt oder nicht.

2. Vorrichtung zum Erfassen eines Ableitstroms einer Batterie (200) nach Anspruch 1, ferner mit einem ersten Spannungsverteilungsknoten, der in einer ersten Leitung zwischen dem positiven und negativen Anschluss der Batterie (200) eingerichtet ist, wobei die Anschlusswahl-Schalteinheit einen ersten und zweiten Schalter aufweist, die zwischen dem ersten Spannungsverteilungsknoten und dem positiven bzw. dem negativen Anschluss der Batterie (200) eingebaut sind.

3. Vorrichtung zum Erfassen eines Ableitstroms einer Batterie (200) nach Anspruch 1, ferner mit einem zweiten Spannungsverteilungsknoten, der in einer zweiten Leitung (2) zwischen dem ersten Spannungsverteilungsknoten und Erde eingebaut ist, wobei der potentialfreie Kondensator (C5) in einer vierten Leitung eingebaut ist, die von einer dritten Leitung (3) abzweigt, die sich vom zweiten Spannungsverteilungsknoten aus erstreckt.

4. Vorrichtung zum Erfassen eines Ableitstroms einer Batterie (200) nach Anspruch 1, ferner mit einer Spannungsanlege-Schalteinheit zum Anlegen der Spannung des positiven oder negativen Anschlusses der Batterie (200), die auf den potentialfreien Kondensator (C5) geladen wird, an die Spannungserfassungseinheit (330).

5. Vorrichtung zum Erfassen eines Ableitstroms einer Batterie (200) nach Anspruch 1, wobei die DC(Gleichstrom)-Spannungsanlegeeinheit (350) aufweist:

einen ersten Schalter, der zwischen dem zweiten Spannungsverteilungsknoten und Erde eingebaut ist,
einen zweiten Schalter, der auf einer leitenden Verbindung, die zwischen dem zweiten Spannungsverteilungsknoten und dem ersten Schalter abzweigt, eingebaut ist,
eine DC-Leistung zum Anlegen einer DC-Spannung an den zweiten Spannungsverteilungsknoten, wenn der zweite Schalter angeschaltet ist.

6. Vorrichtung zum Erfassen eines Ableitstroms einer Batterie (200) nach Anspruch 1, wobei die Ableitstrom-Bestimmungseinheit (340) aufweist:

ein Schaltersteuerglied (343) zum Steuern des Betriebs der Anschlusswahl-Schalteinheit und der Auflade-Schalteinheit,
einen A/D(Analog/Digital)-Wandler (341) zum Umwandeln eines analogen Spannungssignals aus der Spannungserfassungseinheit (330) in ein digitales Spannungssignal und
eine CPU (Central Processing Unit) (342) zum Berechnen eines Ableitwiderstands auf Basis des digitalen Spannungssignals, das vom A/D-Wandler (341) her empfangen wurde, und dann zum Vergleichen des berechneten Ableitwiderstands mit einem Isolationswiderstandsrichtwert, um zu bestimmen, ob ein Ableitstrom auftritt oder nicht.

7. Vorrichtung zum Erfassen eines Ableitstroms einer Batterie (200) nach Anspruch 6, wobei die Spannungserfassungseinheit (330) einen Differentialverstärker zum Erfassen der vom potentialfreien Kondensator (C5) abgegebenen Spannung aufweist.

8. Vorrichtung zum Erfassen eines Ableitstroms einer Batterie (200) nach Anspruch 1, wobei die Ableitstrom-Bestimmungseinheit (340) die Auflade-Schalteinheit vor dem Detektieren der auf den potentialfreien Kondensator (C5) geladenen Spannung so steuert, dass der potentialfreie Kondensator (C5) elektrisch von dem ausgewählten Spannungsdetektionspfad getrennt ist.

9. Vorrichtung zum Erfassen eines Ableitstroms einer Batterie (200) nach Anspruch 1, wobei die Ableitstrom-Bestimmungseinheit (340) den Ableitwiderstand entsprechend der folgenden Gleichung berechnet:

Gleichung

$$R_{leakage} = R_i \times \frac{(E - V_A + V_B)}{(V_A - V_B)} \, ,$$

wobei $R_i$ ein Innenwiderstand der Vorrichtung, E eine Spannung der beiden Enden der Batterie, $V_A$ die auf den potentialfreien Kondensator (C5) geladene Detektionsspannung des positiven Anschlusses (A) und $V_B$ die auf den potentialfreien Kondensator (C5) geladene Detektionsspannung des negativen Anschlusses (B) ist.

**10.** Vorrichtung zum Erfassen eines Ableitstroms einer Batterie (200) nach Anspruch 1, wobei die Ableitstrom-Bestimmungseinheit (340) ferner eine Ableitstrom-Alarmeinheit (344) aufweist, um beim Auftreten eines Ableitstroms sichtbar oder hörbar zu alarmieren, und wobei die Ableitstrom-Alarmeinheit (344) in dem Fall, dass ein Ableitstrom auftritt, einen sichtbaren oder hörbaren Alarm auslöst.

**11.** Vorrichtung zum Erfassen eines Ableitstroms einer Batterie (200) nach Anspruch 1, wobei die Ableitstrom-Bestimmungseinheit (340) bestimmt, dass ein Ableitstrom auftritt, wenn der berechnete Ableitwiderstand kleiner als der Isolationswiderstandsrichtwert ist.

**12.** Batteriepackung, welche die Vorrichtung zum Erfassen eines Ableitstroms einer Batterie (200) umfasst, die in einem der Ansprüche 1 bis 11 festgelegt ist.

**13.** Batteriebetriebene Vorrichtung, welche die Vorrichtung zum Erfassen eines Ableitstroms einer Batterie umfasst, die in einem der Ansprüche 1 bis 11 festgelegt ist.

**14.** Verfahren zum Erfassen eines Ableitstroms einer Batterie (200), umfassend:

(a) Auswählen eines Spannungsdetektionspfades für einen positiven Anschluss (A) der Batterie, Aufladen eines potentialfreien Kondensators (C5) mit einer Detektionsspannung des positiven Anschlusses (A) der Batterie und Erfassen der aufgeladenen Detektionsspannung des positiven Anschlusses (A) in einem Zustand, in dem der potentialfreie Kondensator (C5) vom Spannungsdetektionspfad elektrisch getrennt ist,

(b) Auswählen eines Spannungsdetektionspfades für einen negativen Anschluss (B) der Batterie (200), Anlegen einer DC-Spannung an den negativen Anschluss (B) der Batterie, um den potentialfreien Kondensator (C5) mit einer Detektionsspannung des negativen Anschlusses (B) der Batterie aufzuladen, und Erfassen der aufgeladenen Detektionsspannung des negativen Anschlusses (B) in einem Zustand, in dem der potentialfreie Kondensator (C5) vom Spannungsdetektionspfad elektrisch getrennt ist,

(c) Berechnen eines Ableitwiderstandes auf Basis der erfassten Detektionsspannungen des positiven und negativen Anschlusses und

(d) Vergleichen des berechneten Ableitwiderstandes mit einem Isolationswiderstandsrichtwert, um zu bestimmen, ob ein Ableitstrom auftritt oder nicht.

**15.** Verfahren zum Erfassen eines Ableitstroms einer Batterie (200) nach Anspruch 14, wobei der Ableitwiderstand im Schritt (c) nach der folgenden Gleichung berechnet wird:

Gleichung

$$R_{leakage} = R_i \times \frac{(E - V_A + V_B)}{(V_A - V_B)} \ ,$$

wobei $R_i$ ein Innenwiderstand der Vorrichtung, E eine Spannung der beiden Enden der Batterie, $V_A$ die auf den potentialfreien Kondensator (C5) geladene Detektionsspannung des positiven Anschlusses (A) und $V_B$ die auf den potentialfreien Kondensator (C5) geladene Detektionsspannung des negativen Anschlusses (B) ist.

**16.** Verfahren zum Erfassen eines Ableitstroms einer Batterie (200) nach Anspruch 14, ferner umfassend:

Erzeugen eines sichtbaren oder hörbaren Alarms in dem Fall, dass bestimmt wurde, dass ein Ableitstrom auftritt.

**17.** Verfahren zum Erfassen eines Ableitstroms einer Batterie (200) nach Anspruch 14, wobei bestimmt wird, dass ein Ableitstrom auftritt, wenn der berechnete Ableitwiderstand kleiner als der Isolationswiderstandsrichtwert ist.

**Revendications**

**1.** Appareil pour capter un courant de fuite d'une batterie (200), comprenant :

un condensateur flottant (C5) chargé avec une tension détectée à partir d'une borne positive (A) ou d'une borne négative (B) d'une batterie (200) ;

une unité d'application de tension continue (350) pour appliquer une tension continue sur la borne négative (B) lors de la mesure d'une tension de détection de la borne négative (B) de la batterie (200) ;

une unité de commutation de sélection de borne pour sélectionner un trajet de détection de tension pour la borne positive (A) ou la borne négative (B) ;

une unité de commutation de charge pour charger le condensateur flottant (C5) avec une tension de détection de la borne positive ou négative, détectée à partir du trajet sélectionné de détection de tension, et puis séparer le condensateur flottant (C5) du trajet de détection de tension ;
une unité de captage de tension (330) pour capter la tension de détection de la borne positive ou négative, chargée sur le condensateur flottant séparé (C5) ; et
une unité de détermination de courant de fuite (340) pour calculer une résistance de fuite en fonction des tensions de détection des bornes positive et négative de la batterie (200), captées par l'unité de captage de tension (330), et puis comparer la résistance de fuite calculée à une résistance d'isolation critère pour déterminer si un courant de fuite se produit ou non.

2. Appareil pour capter un courant de fuite d'une batterie (200) selon la revendication 1, comprenant en outre un premier noeud de distribution de tension installé sur une première ligne entre les bornes positive et négative de la batterie (200),
dans lequel l'unité de commutation de sélection de borne comprend des premier et second commutateurs respectivement installés entre le premier noeud de distribution de tension et les bornes positive et négative de la batterie (200).

3. Appareil pour capter un courant de fuite d'une batterie (200) selon la revendication 1, comprenant en outre un second noeud de distribution de tension installé sur une deuxième ligne (2) entre le premier noeud de distribution de tension et une masse,
dans lequel le condensateur flottant (C5) est installé sur une quatrième ligne bifurquant d'une troisième ligne (3) s'étendant à partir du second noeud de distribution de tension.

4. Appareil pour capter un courant de fuite d'une batterie (200) selon la revendication 1, comprenant en outre une unité de commutation d'application de tension pour appliquer la tension de détection de la borne positive ou négative de la batterie (200), chargée sur le condensateur flottant (C5), sur l'unité de captage de tension (330).

5. Appareil pour capter un courant de fuite d'une batterie (200) selon la revendication 1, dans lequel l'unité d'application de tension continue (350) comprend :

un premier commutateur installé entre le second noeud de distribution de tension et une masse ;
un second commutateur installé sur une ligne de conduction bifurquant entre le second noeud de distribution de tension et le premier commutateur ; et
une alimentation CC pour appliquer une tension continue sur le second noeud de distribution de tension lorsque le second commutateur est allumé.

6. Appareil pour capter un courant de fuite d'une batterie (200) selon la revendication 1, dans lequel l'unité de détermination de courant de fuite (340) comprend :

un dispositif de commande de commutation (343) pour commander des fonctionnements de l'unité de commutation de sélection de borne et l'unité de commutation de charge ;
un convertisseur A/N (Analogique/Numérique) (341) pour convertir un signal de tension analogique produit à partir de l'unité de captage de tension (330) en un signal de tension numérique ; et
une CPU (unité centrale de traitement) (342) pour calculer une résistance de fuite en fonction du signal de tension numérique reçu à partir du convertisseur A/N (341) et puis comparer la résistance de fuite calculée à une résistance d'isolation critère pour déterminer si un courant de fuite se produit ou non.

7. Appareil pour capter un courant de fuite d'une batterie (200) selon la revendication 6, dans lequel l'unité de captage de tension (330) comprend un amplificateur différentiel pour capter la tension produite à partir du condensateur flottant (C5).

8. Appareil pour capter un courant de fuite d'une batterie (200) selon la revendication 1, dans lequel l'unité de détermination de courant de fuite (340) commande l'unité de commutation de charge avant de détecter la tension chargée sur le condensateur flottant (C5) pour que le condensateur flottant (C5) soit électriquement séparé du trajet sélectionné de détection de tension.

9. Appareil pour capter un courant de fuite d'une batterie (200) selon la revendication 1, dans lequel l'unité de détermination de courant de fuite (340) calcule une résistance de fuite selon l'équation suivante :

$$R_{Leakage} = R_i \times \frac{(E - V_A + V_B)}{(V_A - V_B)}$$

où $R_i$ est une résistance interne de l'appareil, E est une tension des deux extrémités de la batterie, $V_A$ est la tension de détection de la borne positive (A) chargée sur le condensateur flottant (C5), et $V_B$ est la tension de détection de la borne négative (B) chargée sur le condensateur flottant (C5).

10. Appareil pour capter un courant de fuite d'une batterie (200) selon la revendication 1,

dans lequel l'unité de détermination de courant de fuite (340) comprend en outre une unité d'alarme de courant de fuite (344) pour réaliser une alarme visible ou audible de l'occurrence d'un courant de fuite, et

dans lequel l'unité d'alarme de courant de fuite (344) réalise une alarme visible ou audible au cas où un courant de fuite se produit.

11. Appareil pour capter un courant de fuite d'une batterie (200) selon la revendication 1, dans lequel l'unité de détermination de courant de fuite (340) détermine qu'un courant de fuite se produit, lorsque la résistance de fuite calculée est inférieure à la résistance d'isolation critère.

12. Bloc-batterie, qui comprend l'appareil pour capter un courant de fuite d'une batterie (200) selon une quelconque des revendications 1 à 11.

13. Appareil alimenté par batterie, qui comprend l'appareil pour capter un courant de fuite d'une batterie selon une quelconque des revendications 1 à 11.

14. Procédé pour capter un courant de fuite d'une batterie (200), comprenant :

(a) la sélection d'un trajet de détection de tension pour une borne positive (A) d'une batterie, la charge d'un condensateur flottant (C5) avec une tension de détection de la borne positive (A) de la batterie, et le captage de la tension de détection chargée de la borne positive (A) dans un état dans lequel le condensateur flottant (C5) est séparé électriquement du trajet de détection de tension ;
(b) la sélection d'un trajet de détection de tension pour une borne négative (B) de la batterie (200), l'application d'une tension continue sur la borne négative (B) de la batterie pour charger le condensateur flottant (C5) avec une tension de détection de la borne négative (B) de la batterie, et le captage de la tension de détection chargée de la borne négative (B) dans un état dans lequel le condensateur flottant (C5) est électriquement séparé du trajet de détection de tension ;
(c) le calcul d'une résistance de fuite en fonction des tensions de détection captées des bornes positive et négative ; et
(d) la comparaison de la résistance de fuite calculée à une résistance d'isolation critère pour déterminer si un courant de fuite se produit ou non.

15. Procédé pour capter un courant de fuite d'une batterie (200), selon la revendication 14, dans lequel, dans l'étape (c), la résistance de fuite est calculée selon l'équation suivante :

$$R_{leakage} = R_i \times \frac{(E - V_A + V_B)}{(V_A - V_B)}$$

où $R_i$ est une résistance interne de l'appareil, E est une tension des deux extrémités de la batterie, $V_A$ est la tension de détection de la borne positive (A) chargée sur le condensateur flottant (C5), et $V_B$ est la tension de détection de la borne négative (B) chargée sur le condensateur flottant (C5).

16. Procédé pour capter un courant de fuite d'une batterie (200) selon la revendication 14, comprenant en outre :

la réalisation d'une alarme visuelle ou audible au cas où il est déterminé qu'un courant de fuite se produit.

17. Procédé pour capter un courant de fuite d'une batterie (200) selon la revendication 14, dans lequel il est déterminé qu'un courant de fuite se produit, lorsque la résistance de fuite calculée est inférieure à la résistance d'isolation critère.

# FIG. 1

EP 2 336 794 B1

# FIG. 2

| 341 | | 342 | | 344 |
|---|---|---|---|---|
| A/D CONVERTER | → | CPU | → | LEAKAGE CURRENT ALARMING UNIT |

343

SWITCH CONTROLLER

340

↓

SWITCH CONTROL SIGNAL

# FIG. 3

```
                    ┌─────────────┐
                    │    START    │
                    └──────┬──────┘
                           │
         ┌─────────────────▼──────────────────┐
  S100 ──┤  PRIMARILY CHARGE DETECTION         │
         │  VOLTAGE OF CATHODE TERMINAL        │
         └─────────────────┬──────────────────┘
                           │
         ┌─────────────────▼──────────────────┐
  S110 ──┤  SECONDARILY CHARGE DETECTION       │
         │  VOLTAE OF CATHODE TERMINAL         │
         └─────────────────┬──────────────────┘
                           │
         ┌─────────────────▼──────────────────┐
  S120 ──┤  SENSE CHARGED DETECTION            │
         │  VOLTAGE OF CATHODE TERMINAL        │
         └─────────────────┬──────────────────┘
                           │
         ┌─────────────────▼──────────────────┐
  S200 ──┤  PRIMARILY CHARGE DETECTION         │
         │  VOLTAGE OF ANODE TERMINAL          │
         └─────────────────┬──────────────────┘
                           │
         ┌─────────────────▼──────────────────┐
  S210 ──┤  SECONDARILY CHARGE DETECTION       │
         │  VOLTAE OF ANODE TERMINAL           │
         └─────────────────┬──────────────────┘
                           │
         ┌─────────────────▼──────────────────┐
  S220 ──┤  SENSE CHARGED DETECTION            │
         │  VOLTAGE OF ANODE TERMINAL          │
         └─────────────────┬──────────────────┘
                           │
         ┌─────────────────▼──────────────────┐
  S300 ──┤  CALCULATE LEAKAGE RESISTANCE       │
         └─────────────────┬──────────────────┘
                           │
```

S400 — LEAKAGE RESISTANCE < CRITERION INSULATION RESISTANCE?

YES

NO

S500 — DETERMINE THAT NO LEAKAGE CURRENT OCCURS

DETERMINE THAT LEAKAGE CURRENT OCCURS — S600

MAKE LEAKAGE CURRENT ALARM — S700

END

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102006050529

- FR 2896883